# EUROPÄISCHE PATENTANMELDUNG

(11) **EP 4 047 648 A1**
(43) Veröffentlichungstag der Anmeldung: **24.08.2022**
(21) Anmeldenummer: 21157873.7
(22) Anmeldetag: 18.02.2021
(51) Int. Cl.: H01L 23/488, H01L 21/60, H05K 3/32, H05K 3/34, H01L 21/603

(54) **LEISTUNGSMODUL MIT EINEM MITTELS SINTERN UND LÖTEN MIT EINEM SUBSTRAT VERBUNDENEN LEISTUNGS-BAUELEMENT UND ENTSPRECHENDES HERSTELLUNGSVERFAHREN**

(71) Anmelder: Siemens Aktiengesellschaft, 80333 München (DE)
(72) Erfinder: Bigl, Thomas, 91074 Herzogenaurach (DE); Pfefferlein, Stefan, 90562 Heroldsberg (DE); Wagner, Claus Florian, 90425 Nürnberg (DE)

(57) **Zusammenfassung**

Ein Leistungsmodul (1) umfasst ein Substrat (2), eine elektrisch leitende Zwischenschicht (3), welche auf dem Substrat (2) angeordnet ist und welche einen mittels Sinters hergestellten Fügebereich (4) aufweist, und zumindest ein Leistungs-Bauelement (5), welches jeweils auf der Zwischenschicht (3) und dem gesinterten Fügebereich (4) angeordnet ist und damit verbunden ist (insbesondere am Lastanschluss des Leistungs-Bauelements (5)) und welches jeweils zumindest eine mit der Zwischenschicht (3) verbundene Anschlussstelle (6) (z.B. einen Steueranschluss) aufweist, wobei die Zwischenschicht (3) im Bereich der jeweiligen Anschlussstelle (6) einen mittels eines Lot-Preforms hergestellten Lotbereich (7) aufweist, welcher mit der jeweiligen Anschlussstelle (6) verbunden ist und von dem gesinterten Fügebereich (4) beabstandet bzw. elektrisch isoliert ist. Die große aktive Fläche, welche einem hohen thermomechanischen Stress in den Lebensdauertests unterliegt, kann somit über den gesinterten Fügebereich (4) verbunden werden, welcher eine besonders langlebige, zuverlässige und belastbare mechanische Verbindung des jeweiligen Leistungs-Bauelementes (5) mit dem Substrat (2) gewährleistet. An der jeweiligen Anschlussstelle (6), bspw. dem Gate eines Transistors, ist der thermomechanische Stress üblicherweise weitaus geringer, weshalb dort in der Zwischenschicht (3) ein Lot-Preform zur Herstellung der Verbindung des jeweiligen Leistungs-Bauelementes (5) mit dem Substrat (2) verwendet werden kann, wobei solche Lot-Preforms vergleichsweise kostengünstig erhältlich sind. Weiterhin weist ein elektrisches Gerät (10) zumindest ein derartiges Leistungsmodul (1) auf. Der mittels Sinters hergestellte Fügebereich (4) kann mittels eines Sinter-Preforms hergestellt oder mittels 3D-Druckes, mittels eines Beschichtungsverfahrens oder mittels Sieb-/Schablonendruckes ausgebildet werden. Beim Verfahren zur Herstellung des Leistungsmoduls (1) kann die Zwischenschicht (3) auf die Schmelztemperatur des Lots erhitzt werden, wenn die Schmelztemperatur des Lots höher ist als die Sintertemperatur, oder auf die Sintertemperatur erhitzt werden, wenn die Sintertemperatur höher ist als die Schmelztemperatur des Lots, wobei die Schichtdicke (9) des Sintermaterials für den mittels Sinters hergestellten Fügebereich (4) größer bzw. kleiner sein kann als die Schichtdicke (9) des Lots für den jeweiligen Lotbereich (7), wenn die Sintertemperatur entsprechend kleiner bzw. größer ist als die Schmelztemperatur des Lots. Alternativ kann die Schmelztemperatur des Lots im Wesentlichen gleich der Sintertemperatur sein, wobei die Schichtdicke (9) des Sintermaterials für den mittels Sinters hergestellten Fügebereich (4) im Wesentlichen gleich der Schichtdicke (9) des Lots für den jeweiligen Lotbereich (7) sein kann. Der gesinterte Fügebereich (4) kann einen als Vollmaterial ausgestalteten Sinterkern (4") aufweisen, welcher auf beiden Seiten, das heißt zum Leistungs-Bauelement (5) hin und zum Substrat (2) hin, jeweils ein Sintermaterial (4') aufweist; es wäre auch ein geschichteter, gesinterter Fügebereich (4) denkbar, bei welchem sich Sintermaterial und Vollmaterial schichtweise abwechseln, z.B. Sintermaterial-Vollmaterial-Sintermaterial-Vollmaterial-Sintermaterial.

## Beschreibung

Die Erfindung betrifft ein Leistungsmodul umfassend ein Substrat, eine elektrisch leitende Zwischenschicht, welche auf dem Substrat angeordnet ist und welche einen mittels Sinterns hergestellten Fügebereich aufweist, und zumindest ein Leistungs-Bauelement, welches jeweils auf der Zwischenschicht angeordnet ist und welches jeweils zumindest eine mit der Zwischenschicht verbundene Anschlussstelle aufweist.

Weiterhin betrifft die Erfindung ein jeweiliges elektrisches Gerät aufweisend zumindest ein jeweiliges, derartiges Leistungsmodul.

Schließlich betrifft die Erfindung ein Verfahren zur Herstellung eines derartigen Leistungsmoduls.

Derartige Vorrichtungen bzw. ein derartiges Verfahren kommen in einer Vielzahl von Anwendungen in der Leistungselektronik zum Einsatz.

Bspw. wird zur Verbesserung der Lebensdauer bei Hochleistungshalbleitern bei der Anbindung des Chips zum DCB(direct bonded copper)-Substrat vermehrt auf die Sintertechnologie gesetzt. Die Sinterdepots werden üblicherweise im Schablonendruck mit Sinterpaste hergestellt. Dabei ist es insbesondere bei kleinen Anschlussflächen wie z. B. einer Gateanbindung eines Leistungshalbleiters schwierig, Depots mit einer Nassschichtdicke von mehr als 120 µm herzustellen. Dies wirkt sich vor allem aus, wenn sehr große und sehr kleine Depots in einem Arbeitsgang bzw. eng benachbart zueinander hergestellt werden müssen. Typische Problemstellungen sind dabei ungleichmäßige Schichtdicken, Auslöffeln der Paste aus den Aperturen, überschüssige Paste am Ende der Apertur (Zipfelbildung bzw. so genannte "doggy ears"), Lufteinschlüsse und schlechtes Auslöseverhalten der Paste aus der Apertur.

Bisher gibt es beim Drucken von Sinterpaste keine Lösung für die oben genannten Probleme, was zu einer eingeschränkten technischen Machbarkeit und/oder zu Einbußen bei der Zuverlässigkeit führen kann. Alternativ werden für größere Flächen, d.h. größer als 1,6 mm x 1,6 mm, Sinterpreforms eingesetzt, welche jedoch aufgrund der porösen Sinterpaste auf deren Ober- und Unterseite nicht beliebig klein herstellbar bzw. stanzbar sind. Des Weiteren sind Sinterpreforms meist kostenintensiv und oft nur von einem einzigen Lieferanten als single source verfügbar.

Eine Aufgabe der Erfindung ist es, ein verbessertes Leistungsmodul, ein entsprechendes elektrisches Gerät und ein entsprechendes Verfahren bereitzustellen, welche insbesondere die genannten Nachteile überwinden.

Eine Lösung der Aufgabe ergibt sich durch ein Leistungsmodul der eingangs genannten Art dadurch, dass die Zwischenschicht im Bereich der jeweiligen Anschlussstelle einen mittels eines Lot-Preforms hergestellten Lotbereich aufweist, welcher mit der jeweiligen Anschlussstelle verbunden ist.

Weiterhin ergibt sich eine Lösung der Aufgabe durch ein elektrisches Gerät der eingangs genannten Art dadurch, dass das elektrische Gerät zumindest ein solches, vorgeschlagenes Leistungsmodul aufweist.

Ferner ergibt sich eine Lösung der Aufgabe durch ein Verfahren zur Herstellung des vorgeschlagenen Leistungsmoduls durch folgende Verfahrensschritte:
- Bereitstellen des Substrates,
- Anordnen des Sintermaterials für den zu sinternden Fügebereich und des Lots für den jeweiligen Lotbereich auf dem Substrat zur Ausbildung der Zwischenschicht, wobei das Lot für den jeweiligen Lotbereich im Bereich der jeweiligen Anschlussstelle des jeweiligen Leistungs-Bauelements als Lot-Preform bereitgestellt wird.
- Anordnen des jeweiligen Leistungs-Bauelements auf dem Fügebereich und dem jeweiligen Lotbereich bzw. auf der Zwischenschicht, und
- Erhitzen der Zwischenschicht auf die Schmelztemperatur des Lots bzw. auf die Sintertemperatur.

Das vorgeschlagene Leistungsmodul umfasst ein Substrat, auf welchem eine elektrisch leitende Zwischenschicht angeordnet ist. Diese Zwischenschicht weist einen Fügebereich auf. Diese zeichnet sich insb. dadurch aus, dass die Zwischenschicht dort mittels Sinterns hergestellt ist. Beim Sintern handelt es sich dabei bekanntlich um ein Verfahren zur Herstellung oder Veränderung von Werkstoffen. Dabei werden feinkörnige keramische oder metallische Stoffe - oft unter erhöhtem Druck - erhitzt, wobei die Temperaturen jedoch unterhalb der Schmelztemperatur der Hauptkomponenten bleiben. Auf der Zwischenschicht ist ein Leistungs-Bauelement angeordnet, welches zumindest eine Anschlussstelle aufweist, insbesondere um das Leistung-Bauelement über die jeweilige Anschlussstelle mit einer elektrischen Spannung bzw. einem elektrischen Strom zu versorgen. Die jeweilige Anschlussstelle ist dabei mit der Zwischenschicht verbunden, insbesondere elektrisch verbunden.

Beispielsweise kann der gesinterte Fügebereich einen als Vollmaterial ausgestalteten Sinterkern aufweisen, welcher auf beiden Seiten, das heißt zum Leistungs-Bauelement hin und zum Substrat hin, jeweils ein Sintermaterial aufweist. Zusätzlich wäre auch ein geschichteter, gesinterte Fügebereich denkbar, bei welchem sich Sintermaterial und Vollmaterial schichtweise abwechseln, z.B. Sintermaterial-Vollmaterial-Sintermaterial-Vollmaterial-Sintermaterial.

Die Zwischenschicht weist zusätzlich im Bereich der jeweiligen Anschlussstelle einen Lotbereich auf, welcher mit der jeweiligen Anschlussstelle verbunden ist, insbesondere elektrisch verbunden ist. Der jeweilige Lotbereich weist Lot auf, d. h. einen Verbindungswerkstoff, der Metalle durch Löten verbindet. Das Lot besteht bspw. aus einer Mischung bzw. Legierung unterschiedlicher Metalle. Besonders häufig werden hierfür Blei, Zinn, Zink, Silber, Antimon und Kupfer verwendet. Dabei ist der jeweilige Lotbereich mittels eines Lot-Preforms hergestellt. Bei einem Lot-Preform handelt es sich insbesondere um eine Lot-Vorform bzw. ein Lot-Formteil, bspw. ein Quader, Zylinder, Ring oder dergleichen in einer gewünschten Größe, insb. aus Lotlegierungen. Solche Lot-Preforms sind bspw. auf Gurten bzw. in Trays in vielfältigen Dimensionen lieferbar und lassen sich analog zu SMD("Surface Mount Devices")-Widerständen oder -Kondensatoren verarbeiten.

Als Leistungs-Bauelement kann bspw. ein Halbleiter-Bauelement bzw. Leistungs-Halbleiter eingesetzt werden, d. h. insb. Bauelemente , die z. B. auf Silizium, Galliumnitrid oder Siliziumcarbid basieren und die in der Leistungselektronik für das Steuern und Schalten hoher elektrischer Ströme und Spannungen ausgelegt sind, d. h. insbesondere Ströme von mehr als 1 Ampere und Spannungen von mehr als etwa 24 Volt. Beispiele solcher Bauelemente sind Leistungsdioden, Thyristoren, Triacs und Transistoren, wie zum Beispiel Leistungs-MOSFETs, IGBTs und dergleichen. Weiterhin kann als Leistungs-Bauelement ein elektrischer Widerstand, bspw. ein Messwiderstand, eingesetzt werden.

Oftmals sind derartige Leistungs-Bauelemente vergleichsweise dünne Bauelemente, d. h. die Abmessungen der Grundfläche sind wesentlich größer als die Dicke des jeweiligen Leistungs-Bauelementes senkrecht zur Grundfläche. Insbesondere haben derartige Leistungs-Bauelemente eine im Wesentlichen flache Ober- bzw. Unterseite, bspw. da sie im Wesentlichen quaderförmig oder zylinderförmig sind. Insbesondere liegt eine Seite des Leistungs-Bauelementes auf der Zwischenschicht auf.

Wie erwähnt, weist die Zwischenschicht somit den mittels Sinterns hergestellten Fügebereich (im Folgenden auch "gesinterten Fügebereich") sowie den jeweiligen Lotbereich auf. So wie typische Leistungs-Bauelemente weist auch die Zwischenschicht üblicherweise die Form eines flachen Quaders bzw. Zylinders auf, d.h. mit einer - verglichen zur Dicke der Zwischenschicht - großen Ober- und Unterseite. Dabei ist die Oberseite der Zwischenschicht dem jeweiligen Leistungs-Bauelement zugewandt und die Unterseite der Zwischenschicht dem Substrat zugewandt. Weiterhin nimmt der gesinterte Fügebereich vorzugsweise den größten Bereich der Zwischenschicht ein, sodass der jeweilige Lotbereich vergleichsweise klein ist.

Die erwähnte, jeweilige Anschlussstelle wird insbesondere als Steueranschluss des jeweiligen Leistungs-Bauelements eingesetzt. Das jeweilige Leistungs-Bauelement kann zusätzlich eine weitere Anschlussstelle aufweisen, welche dem mittels Sinterns hergestellten Fügebereich zugewandt ist und als Lastanschluss des jeweiligen Leistungs-Bauelements eingesetzt werden kann. Prinzipiell sind auch mehrere solcher weiterer Anschlussstellen denkbar, welche jeweils als Lastanschluss des jeweiligen Leistungs-Bauelements eingesetzt werden können.

Die erläuterte Ausgestaltung der Zwischenschicht hat mehrere Vorteile. Bspw. wird das jeweilige Leistungs-Bauelement großteils über den gesinterten Fügebereich der Zwischenschicht mit dem Substrat verbunden. Der gesinterte Fügebereich schafft insbesondere eine besonders langlebige, zuverlässige und belastbare mechanische Verbindung des jeweiligen Leistungs-Bauelementes mit dem Substrat, welche auch dem hohen thermomechanische Stress standhält, welchem die Zwischenschicht während der Lebensdauer des Leistungsmoduls unterliegt. Hingegen wird die jeweilige Anschlussstelle, an welcher der thermomechanische Stress deutlich geringer ist, mit kostengünstigeren Lot-Preforms hergestellt, sodass ein Kostenvorteil gegenüber einer vollständig gesinterten Zwischenschicht bei Leistungsmodulen erzielt wird.

Von besonderem Vorteil ist bei dem vorgeschlagenen Leistungsmodul, dass die erläuterte Zwischenschicht bzw. die Verbindung des jeweiligen Leistungs-Bauelementes mit dem Substrat über die erläuterte Zwischenschicht besonders kostengünstig und einfach hergestellt werden kann. Dies liegt u.a. daran, dass die Ausbildung des gesinterten Fügebereichs und des jeweiligen Lotbereichs der Zwischenschicht insbesondere in einem Arbeitsschritt gelingt. Dies ist bspw. dadurch möglich, dass während des Arbeitsschrittes des Sinterns des mittels Sinterns hergestellten Fügebereichs das Lot-Preform aufgeschmolzen werden kann bzw. während des Arbeitsschrittes des Lötens des Lotbereichs der Sinter-Werkstoff gesintert werden kann. Im Resultat bilden sich während dieses Arbeitsschrittes sowohl der gesinterte Fügebereich als auch der jeweilige Lotbereich aus. Weiterhin ergibt sich als Vorteil, dass das Sintermaterial, aus welchem der gesinterte Fügebereich gebildet wird, nur begrenzt komprimierbar ist, wodurch eine unzulässige Verdrängung des Lots während des Aufschmelzens des Lot-Preforms während dieses Arbeitsschrittes verhindert wird.

Bei einer vorteilhaften Ausgestaltung der Erfindung ist der mittels Sinterns hergestellte Fügebereich mittels eines Sinter-Preforms hergestellt.

Bei einem Sinter-Preform handelt es sich insbesondere um eine Sinter-Vorform bzw. ein Sinter-Formteil, bspw. ein Quader, Zylinder, Ring oder dergleichen aus dem zu sinternden Werkstoff. Auch Sinter-Preforms sind bspw. auf Gurten bzw. in Trays in gängigen Dimensionen lieferbar und lassen sich analog zu SMD("Surface Mount Devices")-Widerständen oder - Kondensatoren verarbeiten.

Die Verwendung eines Sinter-Preforms zusammen mit einem jeweiligen Lot-Preform ermöglicht eine besonders leicht herstellbare Verbindung des jeweiligen Leistungs-Bauelements mit dem Substrat. Insbesondere können durch die Kombination eines Sinter-Preforms mit einem jeweiligen Lot-Preform große, gesinterte Bereiche und kleine, gelötete Bereiche der Zwischenschicht in einem Sinter- bzw. Arbeitsschritt verbunden werden, bspw. auch ohne eine zusätzliche Aktivierung des Lots. Hierbei kann für die aktive, große Fläche ein Sinter-Preform verwendet werden, welches ausschlaggebend für die endgültige Dicke der Zwischenschicht ist. Für die kleine, gelötete Fläche, zum Beispiel am Gate eines als Transistor ausgestalteten Leistung-Bauelements, kann ein Lot-Preform verwendet werden, das während des Sintervorgangs mit aufschmilzt. Dank der nur begrenzt komprimierbaren Sinter-Preform kann dabei eine unzulässige Verdrängung des Lots beim Aufschmelzen auf der kleinen Fläche während des Sintervorgangs verhindert werden.

Die große aktive Fläche, welche einem hohen thermomechanischen Stress in den Lebensdauertests unterliegt, kann somit über den gesinterten Fügebereich verbunden werden, welcher eine besonders langlebige, zuverlässige und belastbare mechanische Verbindung des jeweiligen Leistungs-Bauelementes mit dem Substrat gewährleistet. An der jeweiligen Anschlussstelle, bspw. dem oben erläuterten Gate eines Transistors, ist der thermomechanische Stress üblicherweise weitaus geringer, weshalb dort in der Zwischenschicht ein Lot-Preform zur Herstellung der Verbindung des jeweiligen Leistungs-Bauelementes mit dem Substrat verwendet werden kann. Wie bereits erwähnt, sind solche Lot-Preforms vergleichsweise kostengünstig erhältlich.

Bei einer alternativen vorteilhaften Ausgestaltung der Erfindung ist der mittels Sinterns hergestellte Fügebereich mittels 3D-Druckes, mittels eines Beschichtungsverfahrens oder mittels Sieb-/Schablonendruckes ausgebildet.

Alternativ zur Verwendung eines Sinter-Preforms kann der zu sinternde Werkstoff der Zwischenschicht auch mittels 3D-Druckes, mittels eines Beschichtungsverfahrens oder mittels Sieb-/Schablonendruckes ausgebildet werden bzw. auf dem Substrat angebracht bzw. angeordnet werden. Diese alternativen Verfahren können gegenüber der Verwendung eines Sinter-Preforms den Vorteil haben, dass besonders feingliedrige oder auch komplizierte Geometrien des gesinterten Fügebereichs realisierbar sind. Bspw. können mittels solcher alternativer Verfahren Leistungsmodule mit komplexen Leistungs-Bauelementen aufweisend viele Anschlussstellen oder Leistungsmodule mit vielen (solcher) Leistungs-Bauelemente realisiert werden.

Denkbar ist weiterhin, dass für ein Leistungsmodul sowohl ein oder mehrere Sinter-Preforms als auch eines oder mehrere der erwähnten alternativen Verfahren zum Einsatz kommen, um ein oder mehrere gesinterte Fügebereiche herzustellen.

Bei einer weiteren vorteilhaften Ausgestaltung der Erfindung ist der jeweilige Lotbereich bzw. das jeweilige Lot-Preform flussmittelfrei.

Ein Flussmittel ist hierbei ein beim Löten zugegebener Stoff, der eine bessere Benetzung des Werkstücks durch das Lot bewirkt. Es entfernt die an den Oberflächen aufliegenden Oxide durch chemische Reaktion, insbesondere mittels Reduktion. Gleiches gilt für Oxide, die während des Lötvorgangs durch den Sauerstoff der Luft entstehen. Flussmittel setzen außerdem die Grenzflächenspannungen herab. Je nach den speziellen Anforderungen bzw. Gegebenheiten, können Flussmittel säurehaltig oder lösemittelhaltig sein oder einen Aktivator, wie Zinkchlorid, Ammoniumchlorid oder organische Salze, aufweisen.

Flussmittelfrei bedeutet dabei insbesondere, dass das Lot des Lot-Preforms kein oder nahezu kein Flussmittel aufweist. Bspw. ist das Lot des Lot-Preforms flussmittelfrei, wenn es ausschließlich bzw. nahezu ausschließlich eine Mischung bzw. Legierung unterschiedlicher Metalle aufweist. Dabei wird angenommen, dass ein Lot "nahezu" kein Flussmittel aufweist, wenn die im Lot enthaltene Menge des Flussmittels lediglich höchstens vernachlässigbare Wirkungen bezüglich Benetzung der Werkstücke, Entfernung der Oxide auf den zu lötenden Werkstücken und/oder Herabsetzung der Grenzflächenspannungen entfaltet. Insbesondere wird angenommen, dass ein Lot "nahezu" kein Flussmittel aufweist, wenn das Lot lediglich unerhebliche bzw. unerwünschte Verunreinigungen mit Flussmittel aufweist. Obwohl beim Löten oftmals Flussmittel verwendet werden, gelingt die Ausbildung der jeweiligen Lotschicht und die Verbindung des jeweiligen Leistungs-Bauelementes mit dem Substrat mittels des flussmittelfreien Lot-Preforms bzw. Lotbereichs, da bei dem vorgeschlagenen Leistungsmodul das jeweilige Leistungs-Bauelement über den mittels Sinters hergestellten Fügebereich der Zwischenschicht mittels Sintern auf dem Substrat befestigt wird. Entsprechend weisen sowohl das jeweilige Leistungs-Bauelement als auch das Substrat an der jeweiligen, dem anderen Werkstück zugewandten Oberfläche bzw. Auflagefläche auf der Zwischenschicht eine Edelmetalloberfläche, bspw. Gold oder Silber, auf. Da diese Edelmetalloberflächen nicht oder praktisch nicht oxidieren, ist das für das Löten normalerweise notwendige Flussmittel nicht notwendig.

Bei einer weiteren vorteilhaften Ausgestaltung der Erfindung sind der mittels Sinterns hergestellte Fügebereich und der jeweilige Lotbereich zwischen dem Substrat und dem jeweiligen Leistungs-Bauelement nebeneinander angeordnet und weisen im Wesentlichen dieselbe Schichtdicke auf.

Üblicherweise ist die Zwischenschicht flach ausgestaltet, wobei auf ihrer flachen Oberseite das jeweilige Leistungs-Bauelement und auf ihrer flachen Unterseite das Substrat angeordnet ist. Innerhalb der Zwischenschicht sind der gesinterte Fügebereich sowie der jeweilige Lotbereich insbesondere derart nebeneinander angeordnet, dass sich der gesinterte Fügebereich bzw. der Lotbereich durchgehend von der flachen Oberseite der Zwischenschicht zur gegenüberliegenden, flachen Unterseite Zwischenschicht erstreckt. Weiterhin nimmt der gesinterte Fügebereich vorzugsweise den größten Bereich der Zwischenschicht ein, sodass der jeweilige Lotbereich vergleichsweise klein ist.

Die Schichtdicke des gesinterten Fügebereichs entspricht dabei im Wesentlichen der jeweiligen Schichtdicke des jeweiligen Lotbereichs, sodass die Zwischenschicht eine im Wesentlichen konstante Schichtdicke aufweist. Kleinere Abweichungen können dabei tolerierbar sein, bspw. solange sich innerhalb des gesinterten Fügebereichs und/oder des jeweiligen Lotbereichs keine oder nur vernachlässigbare Hohlräume bzw. Lufteinschlüsse bilden, bspw. dadurch, dass der gesinterte Fügebereich bzw. der jeweilige Lotbereich keine konstante Schichtdicke aufweist. Weiterhin können kleinere Abweichungen noch tolerierbar sein, sofern lediglich vernachlässigbare Zipfelbildung vorliegt.

Beispielhaft können die Zwischenschicht bzw. der gesinterte Fügebereich und der jeweilige Lotbereich eine Dicke von 10 µm bis 300 µm aufweisen, vorzugsweise von 50 µm bis 150 µm bzw. von 90 µm bis 110 µm, d. h. etwa 100 µm. Je nach Ausgestaltung des Leistungsmoduls können Toleranzen der Schichtdicke der Zwischenschicht bzw. des gesinterten Fügebereichs und/oder des jeweiligen Lotbereichs von ±20%, insb. ±10% oder lediglich ±5% noch akzeptabel sein.

Die im Zusammenhang mit dieser vorteilhaften Ausgestaltung genannten Schichtdicken beziehen sich dabei insbesondere auf das fertig hergestellte Leistungsmodul, d.h. den Status nach dem Verbinden des jeweiligen Leistungs-Bauelementes mit dem Substrat durch Erhitzen der Zwischenschicht.

Bei einer weiteren vorteilhaften Ausgestaltung der Erfindung weist der jeweilige Lotbereich einen Querschnitt von höchstens ca. 9 mm², insb. von höchstens ca. 4 mm², auf.

Der jeweilige Lotbereich kann dabei - in einer Ebene parallel zur flachen Oberseite des Substrats - einen runden bzw. kreisförmigen oder auch einen rechteckig bzw. quadratischen Querschnitt aufweisen. Bei quadratischen Querschnitten können die Abmessung bspw. 3 mm x 3 mm bzw. 2 mm x 2 mm sein. Auch kleinere Abmessungen wie zum Beispiel 1,6 mm x 1,6 mm bzw. auch unter 2 mm² oder unter 1 mm², wie z.B. 0,5 mm x 1 mm, sind denkbar. Dabei können die angegebenen Querschnitte insbesondere der Querschnittsfläche des jeweiligen Lotbereichs entsprechen, nachdem die Verbindung des jeweiligen Leistungs-Bauelementes mit dem Substrat hergestellt wurde.

Bei einer weiteren vorteilhaften Ausgestaltung der Erfindung umfasst das Substrat ein Direct-Bonded-Copper(DCB)-Substrat, ein Insulated-Metal-Substrate (IMS), ein Active-Metal-Brazing(AMB)-Substrat oder eine Leiterplatte, wobei das Substrat an seiner, der Zwischenschicht zugewandten Seite eine Edelmetalloberfläche aufweist.

Bei dem DCB-Substrat und dem IMS handelt es sich insbesondere um Trägerstrukturen, auf die elektrische Leiterbahnen und ggf. ein oder mehrere Halbleiterchips, Leistungs-Bauelemente oder andere Bauelemente aufgebracht sind bzw. werden können.

Die Edelmetalloberfläche kann bspw. Gold oder Silber aufweisen, wobei das Substrat bspw. entsprechend beschichtet ist.

Das vorgeschlagene Gerät aufweisend zumindest ein solches Leistungsmodul kann insbesondere als Gleichrichter, Wechselrichter bzw. ganz allgemein Umrichter oder Stromrichter ausgestaltet sein bzw. einen solchen umfassen. Insbesondere kann das vorgeschlagene Leistungsmodul oder ein entsprechendes Gerät bei industriellen Anwendungen, elektrisch oder hybridangetriebenen Fahrzeugen, wie zum Beispiel bei Zügen, Autos, Schiffen, Booten oder Flugzeugen, eingesetzt werden.

Wie oben erwähnt, können gemäß dem vorgeschlagenen Verfahren die einzelnen Komponenten des vorgeschlagenen Leistungsmoduls bereitgestellt werden und passend angeordnet werden. Die Zwischenschicht kann auf bzw. leicht über die Schmelztemperatur des Lots bzw. auf bzw. leicht über die Sintertemperatur erhitzt werden, um das vorgeschlagene Leistungsmodul herzustellen. Insbesondere wird hierzu die komplette Anordnung auf bzw. leicht über die entsprechende Temperatur erhitzt. Weiterhin kann auf die Zwischenschicht bzw. die komplette Anordnung, insbesondere je nach Sinter-Werkstoff, Druck ausgeübt werden. Beispielsweise können der Sinter-Werkstoff und das jeweilige Lot-Preform derart auf dem Substrat angeordnet werden, dass auf dem Substrat vor dem Erhitzen noch Hohlräume zwischen dem Sinter-Werkstoff und dem jeweiligen Lot-Preform verbleiben.

Bei einer weiteren vorteilhaften Ausgestaltung der Erfindung wird die Zwischenschicht auf die Schmelztemperatur des Lots erhitzt, wenn die Schmelztemperatur des Lots höher ist als die Sintertemperatur, oder auf die Sintertemperatur erhitzt, wenn die Sintertemperatur höher ist als die Schmelztemperatur des Lots.

Denkbar sind dabei zwei Varianten, die im Folgenden erläutert werden.

Gemäß einer ersten Variante kann zunächst gelötet und anschließend gesintert werden. Hierzu kann insbesondere ein niederschmelzendes Lot verwendet werden, welches eine Schmelztemperatur aufweist, die kleiner als die Sintertemperatur ist. Während des Herstellungsprozesses des vorgeschlagenen Leistungsmoduls wird die Zwischenschicht bzw. Anordnung zunächst auf die Schmelztemperatur des Lots erhitzt, wodurch sich die Lotverbindung ausbildet. Dann wird die Zwischenschicht bzw. Anordnung durch weitere Temperaturerhöhung auf die Sintertemperatur erhitzt und ggf. Druck auf die Zwischenschicht bzw. Anordnung ausgeübt, wodurch die Sinterverbindung geschaffen wird. Das Lot bleibt dabei vorzugsweise schmelzflüssig. Die Schaffung der Sinterverbindung kann dabei in einem Prozessschritt zusammen mit der Schaffung der Lotverbindung oder in einem davon abgetrennten Prozessschritt durchgeführt werden.

Gemäß einer zweiten Variante kann zunächst gesintert und anschließend gelötet werden. Hierzu kann insbesondere ein hochschmelzendes Lot verwendet werden, welches eine Schmelztemperatur aufweist, die größer als die Sintertemperatur ist. Während des Herstellungsprozesses des vorgeschlagenen Leistungsmoduls wird die Zwischenschicht bzw. Anordnung zunächst auf die Sintertemperatur erhitzt und ggf. Druck auf die Zwischenschicht bzw. Anordnung ausgeübt, wodurch die Sinterverbindung geschaffen wird. Dann wird die Zwischenschicht bzw. Anordnung durch weitere Temperaturerhöhung auf die Schmelztemperatur des Lots erhitzt, wodurch die Lotverbindung geschaffen wird. Da das Lot beim Aufschmelzen durch die Oberflächenspannung zur Kugelbildung neigt, können bei dieser Variante insbesondere Hohlräume überbrückt werden, die nach dem Sintern noch vorhanden sein könnten. Die Schaffung der Lotverbindung kann dabei in einem Prozessschritt zusammen mit der Schaffung der Sinterverbindung oder in einem davon abgetrennten Prozessschritt durchgeführt werden.

Bei einer weiteren vorteilhaften Ausgestaltung der Erfindung ist dabei die Schichtdicke des Sintermaterials für den mittels Sinterns hergestellten Fügebereich größer bzw. kleiner ist als die Schichtdicke des Lots für den jeweiligen Lotbereich, wenn die Sintertemperatur kleiner bzw. größer ist als die Schmelztemperatur des Lots.

Gemäß der ersten Variante, bei welcher zunächst gelötet und anschließend gesintert werden kann, ist die Schichtdicke des Sintermaterials somit kleiner als die Schichtdicke des Lots. Und gemäß der zweiten Variante, bei welcher zunächst gesintert und anschließend gelötet werden kann, ist die Schichtdicke des Sintermaterials somit größer als die Schichtdicke des Lots. Da das Lot beim Aufschmelzen durch die Oberflächenspannung zur Kugelbildung neigt, können bei dieser Variante insbesondere Hohlräume überbrückt werden, die nach dem Sintern noch vorhanden sein könnten. Die genannten Schichtdicken des Sintermaterials bzw. des Lots beziehen sich dabei auf den Status der Anordnung, bevor die beiden Verbindungen durch Erhitzen und ggf. Ausüben von Druck geschaffen werden.

Vorzugsweise ist dabei die dickere Schicht um 10 % bis 40 % dicker als die dünnere Schicht, vorzugsweise 15 % bis 25 %. In einigen Beispielen ist die dickere Schicht dabei ca. 10 µm bis 40 µm dicker als die dünnere Schicht, vorzugsweise 15 µm bis 25 µm.

Bei einer alternativen vorteilhaften Ausgestaltung der Erfindung ist die Schmelztemperatur des Lots im Wesentlichen gleich der Sintertemperatur.

Gemäß dieser weiteren Variante kann praktisch gleichzeitig gelötet und gesintert werden. Hierzu können ein Lot und ein Sinterwerkstoff verwendet werden, wobei die Schmelztemperatur des Lots im Wesentlichen der Sintertemperatur entspricht. Als im Wesentlichen gleiche Temperaturen werden dabei solche angesehen, die sich weniger als 10 K, insb. weniger als 5 K, voneinander unterscheiden. Dabei kann die Sintertemperatur ggf. von der Ausübung von Druck auf die Zwischenschicht bzw. Anordnung abhängen. Insbesondere können die Temperaturen beim Sinter- und Lötprozess je nach Löt- und Sinterverfahren recht ähnlich sein, zum Beispiel ca. 240° zum Aufschmelzen des Lotes und zum Sintern. Somit ist das Erhitzen der Zwischenschicht bzw. der Anordnung zum Zweck des Sinterns ausreichend, um ein Aufschmelzen des Lotes und eine zuverlässige Ausbildung der Lötstelle zu gewährleisten. Insbesondere braucht der Sinterprozess deshalb nicht speziell angepasst werden. Von Vorteil ist bei dieser Variante, dass die Lotverbindung und die Sinterverbindung besonders leicht in einem Arbeitsschritt hergestellt werden können.

In manchen Beispielen kann die Schichtdicke des Lot-Preforms etwas dicker als die Schichtdicke des Sinter-Werkstoffs gewählt werden, d.h. bspw. um 5 % bis 15 % bzw. ca. 5 µm bis 15 µm dicker. Die genannten Schichtdicken des Sintermaterials bzw. des Lots beziehen sich dabei auf den Status der Anordnung, bevor die beiden Verbindungen durch Erhitzen und ggf. Ausüben von Druck geschaffen werden.

Bei einer weiteren vorteilhaften Ausgestaltung der Erfindung ist dabei die Schichtdicke des Sintermaterials für den mittels Sinterns hergestellten Fügebereich im Wesentlichen gleich der Schichtdicke des Lots für den jeweiligen Lotbereich.

Vorzugsweise entspricht die Dicke des Lot-Preforms im Wesentlichen der Dicke des Sinter-Werkstoffs, bevor die beiden Verbindungen durch Erhitzen und ggf. Ausüben von Druck geschaffen werden. Insbesondere ist die Dicke des Lot-Preforms bis auf weniger als ± 10 µm bzw. ± 10 %, vorzugsweise weniger als ± 5 µm bzw. ± 5 %, gleich der Dicke des Sinter-Werkstoffs. Die genannten Schichtdicken des Sintermaterials bzw. des Lots beziehen sich dabei auf den Status der Anordnung, bevor die beiden Verbindungen durch Erhitzen und ggf. Ausüben von Druck geschaffen werden.

Das oben erläuterte, vorgeschlagene Verfahren zur Herstellung des vorgeschlagenen Leistungsmoduls kann dabei insbesondere die im Zusammenhang mit den erläuterten vorteilhaften Ausgestaltungen Leistungsmoduls erläuterten Verfahrensschritte umfassen. Dies betrifft insbesondere die erläuterten Verfahrensschritte zur Herstellung der Zwischenschicht bzw. des jeweiligen Lotbereichs und ggf. des mittels Sinters hergestellten Fügebereichs.

Im Folgenden wird die Erfindung anhand der in den Figuren dargestellten Ausführungsbeispiele näher beschrieben und erläutert. Es zeigen:
- FIG 1-2: ein erstes und zweites Ausführungsbeispiel des vorgeschlagenen Leistungsmoduls,
- FIG 3-6: ein Ablaufdiagramm eines ersten bis vierten Ausführungsbeispiels des vorgeschlagenen Verfahrens,
- FIG 7: einen ersten Zwischenstand bei der Herstellung eines dritten Ausführungsbeispiel des vorgeschlagenen Leistungsmoduls,
- FIG 8-9: einen ersten und zweiten Zwischenstand bei der Herstellung eines vierten Ausführungsbeispiels des vorgeschlagenen Leistungsmoduls,
- FIG 10-11: Querschnitte durch ein fünftes Ausführungsbeispiel des vorgeschlagenen Leistungsmoduls, und
- FIG 12: ein Ausführungsbeispiel des vorgeschlagenen elektrischen Gerätes.

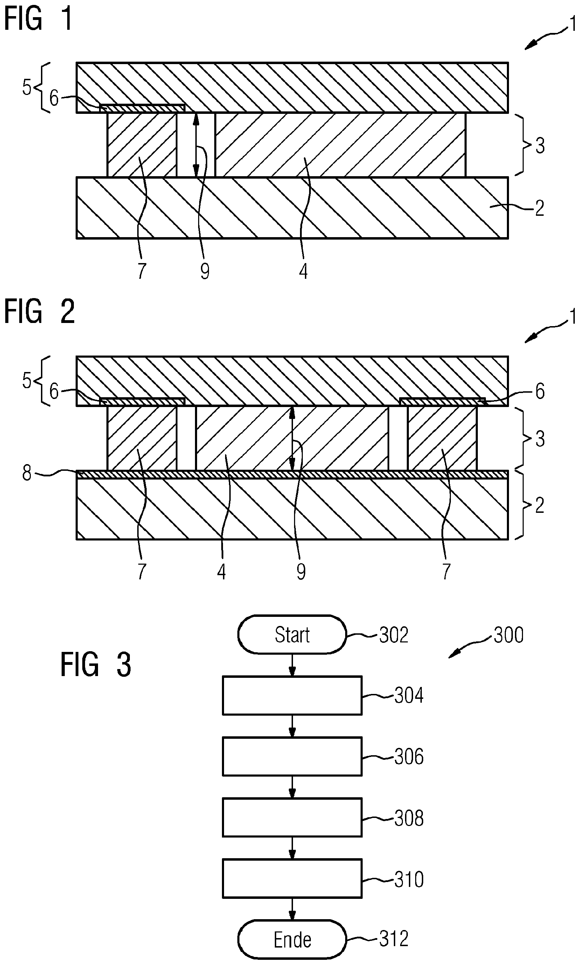

Figur 1 zeigt ein erstes Ausführungsbeispiel des vorgeschlagenen Leistungsmoduls 1, wobei ein Querschnitt durch das Leistungsmodul 1 dargestellt ist.

Das Leistungsmodul 1 weist ein Substrat 2 auf, auf welchem eine elektrisch leitende Zwischenschicht 3 angeordnet ist. Die Zwischenschicht 3 weist einen mittels Sinterns hergestellten Fügebereich 4 auf. Weiterhin weist das Leistungsmodul 1 ein Leistungs-Bauelement 5 auf, welches auf der Zwischenschicht 3 angeordnet ist und welches eine oder mehrere mit der Zwischenschicht 3 verbundene Anschlussstelle(n) 6 aufweist. Ferner weist die Zwischenschicht 3 im Bereich der Anschlussstelle 6 einen Lotbereich 7 auf, welcher mit der Anschlussstelle 6 verbunden ist und welcher mittels eines Lot-Preforms hergestellt ist.

Die Anschlussstelle 6 kann insbesondere als Steueranschluss des Leistungs-Bauelements 5 eingesetzt werden. Weiterhin kann das Leistungs-Bauelement 5 zusätzlich eine weitere Anschlussstelle aufweisen, welche dem mittels Sinterns hergestellten Fügebereich 4 zugewandt ist und als Lastanschluss des Leistungs-Bauelements 5 eingesetzt werden kann. Prinzipiell sind auch mehrere solcher weiterer Anschlussstellen denkbar, welche jeweils als Lastanschluss des jeweiligen Leistungs-Bauelements 5 eingesetzt werden können.

Vorzugsweise sind dabei sowohl bei dem Leistungs-Bauelement 5 als auch auf dem Substrat 2 bereits Anschlussstrukturen zur Kontaktierung der Zwischenschicht 3 vorhanden. So kann insbesondere das Substrat 2 strukturiert ausgeführt sein, wobei die genannten Strukturen in Figur 1 nicht näher dargestellt sind. Die Strukturierung kann z.B. dadurch erreicht werden, dass das Substrat 2 eine elektrisch leitendende Oberfläche aufweist, welche der Zwischenschicht 3 zugewandt ist, wobei diese Oberfläche elektrisch nichtleitende Aussparungen bzw. Lücken aufweist, wodurch zwei oder mehr Bereiche dieser Oberfläche elektrisch voneinander isoliert sind. Damit kann insbesondere auch eine elektrische Isolierung des Lotbereichs 7 vom mittels Sinterns hergestellten Fügebereich 4 geschaffen werden. Beispielsweise kann das Substrat 2 auch mehrlagig ausgestaltet sein.

Der gesinterte Fügebereich 4 kann bspw. mittels eines Sinter-Preforms hergestellt sein. Alternativ oder zusätzlich kann der gesinterte Fügebereich 4 mittels 3-D-Druckes, mittels eines Beschichtungsverfahrens oder mittels Sieb-/Schablonendruckes ausgebildet sein.

Insbesondere kann der jeweilige Lotbereich 7 bzw. das jeweilige Lot-Preform flussmittelfrei sein.

Wie in Figur 1 dargestellt, können der gesinterte Fügebereich 4 und der Lotbereich 7 zwischen dem Substrat 2 und dem Leistungs-Bauelement 5 nebeneinander angeordnet sein und im Wesentlichen dieselbe Schichtdicke 9 aufweisen.

Vorzugsweise weist der jeweilige Lotbereich 7 einen Querschnitt von höchstens ca. 9 mm², insbesondere von höchstens 4 mm², auf, wobei eine Ebene parallel zur flachen Oberseite des Substrats 2 betrachtet wird.

Beispielsweise kann das Substrat 2 ein Direct-Bonded-Copper(DCB)-Substrat, ein Insulated-Metal-Substrate (IMS), ein Active-Metal-Brazing(AMB)-Substrat oder eine Leiterplatte umfassen.

Figur 2 zeigt ein zweites Ausführungsbeispiel des vorgeschlagenen Leistungsmoduls 1, wobei wiederum ein Querschnitt durch das Leistungsmodul 1 dargestellt ist. Gleiche Bezugszeichen wie in Figur 1 bezeichnen dabei gleiche Gegenstände.

Das Substrat 2 weist an seiner, der Zwischenschicht 3 zugewandten Seite eine Edelmetalloberfläche 8 auf, bspw. aufweisend Gold oder Silber. Dabei umfasst das Substrat 2 ein Direct-Bonded-Copper(DCB)-Substrat, ein Insulated-Metal-Substrate (IMS), ein Active-Metal-Brazing(AMB)-Substrat oder eine Leiterplatte.

Vorzugsweise sind dabei sowohl bei dem Leistungs-Bauelement 5 als auch auf dem Substrat 2, insbesondere bzgl. der Edelmetalloberfläche 8, bereits Anschlussstrukturen zur Kontaktierung der Zwischenschicht 3 vorhanden. So kann insbesondere die Edelmetalloberfläche 8 strukturiert ausgeführt sein, wobei die genannten Strukturen in Figur 2 nicht näher dargestellt sind. Die Strukturierung kann z.B. dadurch erreicht werden, dass die Edelmetalloberfläche 8 eine elektrisch leitendende Oberfläche ausbildet, wobei diese Oberfläche elektrisch nichtleitende Aussparungen bzw. Lücken aufweist, wodurch zwei oder mehr Bereiche dieser Oberfläche elektrisch voneinander isoliert sind. Damit kann insbesondere auch eine elektrische Isolierung des Lotbereichs 7 vom mittels Sinterns hergestellten Fügebereich 4 geschaffen werden. Beispielsweise kann das Substrat 2 auch mehrlagig ausgestaltet sein.

Weiterhin weist das Leistungsmodul 1 zwei Anschlussstellen 6 auf und die Zwischenschicht weist zwei Lotbereiche 7 auf. Dabei ist der jeweilige Lotbereich 7 im Bereich der jeweiligen Anschlussstelle 6 angeordnet und mit der jeweiligen Anschlussstelle 6 verbunden. Der jeweilige Lotbereich 7 ist dabei mittels eines Lot-Preforms hergestellt.

Die zwei Anschlussstellen 6 werden insbesondere als Steueranschlüsse des Leistungs-Bauelements 5 eingesetzt. Das Leistungs-Bauelement 5 kann zusätzlich eine oder mehrere weitere Anschlussstelle(n) aufweisen, welche dem mittels Sinterns hergestellten Fügebereich 4 zugewandt ist bzw. sind und als Lastanschluss bzw. Lastanschlüsse des Leistungs-Bauelements 5 eingesetzt werden kann bzw. können.

Figur 3 zeigt ein Ablaufdiagramm 300 eines erstes Ausführungsbeispiels des vorgeschlagenen Verfahrens. Der Ablauf startet mit Schritt 302 und umfasst zumindest die folgenden Schritte. Bei Schritt 304 wird das Substrat bereitgestellt. Bei Schritt 306 werden das Sintermaterial für den gesinterte Fügebereich und das Lot für den jeweiligen Lotbereich auf dem Substrat zur Ausbildung der Zwischenschicht bereitgestellt, wobei das Lot für den jeweiligen Lotbereich im Bereich der jeweiligen Anschlussstelle des jeweiligen Leistungs-Bauelements und als Lot-Preform bereitgestellt wird. Bei Schritt 308 wird das jeweilige Leistungs-Bauelement auf dem mittels Sinterns hergestellten Fügebereich und dem jeweiligen Lotbereich bzw. auf der Zwischenschicht angeordnet. Bei Schritt 310 wird die Zwischenschicht auf die Schmelztemperatur des Lots bzw. auf die Sintertemperatur erhitzt. Der Ablauf endet mit Schritt 312.

Bei vorteilhaften Ausgestaltungen des Verfahrens kann das Ablaufdiagramm noch weitere Schritte umfassen, die weiter oben und unten erläutert werden.

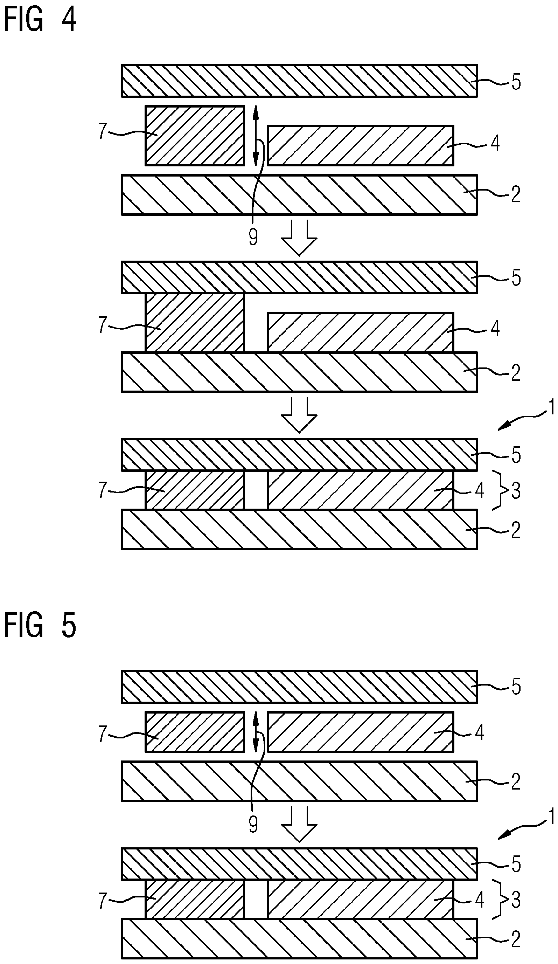

Figur 4 zeigt ein Ablaufdiagramm eines zweiten Ausführungsbeispiels des vorgeschlagenen Verfahrens. Das Substrat 2, das Sintermaterial für den gesinterte Fügebereich 4, das Lot-Preform für den Lotbereich 7 und das Leistungs-Bauelement 5 werden bereitgestellt und passend angeordnet. Lediglich aus Gründen der Übersichtlichkeit wird dabei die jeweilige Anschlussstelle 6 in Figur 4 nicht näher dargestellt.

Bei diesem Ausführungsbeispiel wird zunächst gelötet und anschließend gesintert. Hierzu kann insbesondere ein niederschmelzendes Lot verwendet werden, welches eine Schmelztemperatur aufweist, die kleiner als die Sintertemperatur ist. Während des Herstellungsprozesses des vorgeschlagenen Leistungsmoduls 1 wird die Zwischenschicht 3 bzw. Anordnung zunächst auf die Schmelztemperatur des Lots erhitzt, wodurch die Lotverbindung geschaffen wird. Das Lot bleibt dabei vorzugsweise schmelzflüssig. Dann wird die Zwischenschicht 3 bzw. Anordnung durch weitere Temperaturerhöhung auf die Sintertemperatur erhitzt und ggf. Druck auf die Zwischenschicht 3 bzw. Anordnung ausgeübt, wodurch die Sinterverbindung geschaffen wird. Die Schaffung der Sinterverbindung kann dabei in einem Prozessschritt zusammen mit der Schaffung der Lotverbindung oder in einem, davon abgetrennten Prozessschritten durchgeführt werden.

Vorzugsweise ist dabei das Lot-Preform um 10 % bis 40 % dicker als der Sinter-Werkstoff, vorzugsweise 15 % bis 25 %. In einigen Beispielen ist das Lot-Preform dabei ca. 10 µm bis 40 µm dicker als der Sinter-Werkstoff, vorzugsweise 15 µm bis 25 µm. Die genannten Schichtdicken des Sintermaterials bzw. des Lots beziehen sich dabei auf den Status der Anordnung, bevor die beiden Verbindungen durch Erhitzen und ggf. Ausüben von Druck geschaffen werden.

Figur 5 zeigt ein Ablaufdiagramm eines dritten Ausführungsbeispiels des vorgeschlagenen Verfahrens. Wiederum werden das Substrat 2, das Sintermaterial für den Fügebereich 4, das Lot-Preform für den Lotbereich 7 und das Leistungs-Bauelement 5 bereitgestellt und passend angeordnet. Ebenfalls lediglich aus Gründen der Übersichtlichkeit wird dabei die jeweilige Anschlussstelle 6 in Figur 5 nicht näher dargestellt.

Gemäß diesem Ausführungsbeispiel wird praktisch gleichzeitig gelötet und gesintert. Hierzu können ein Lot und ein Sinterwerkstoff verwendet werden, wobei die Schmelztemperatur des Lots im Wesentlichen der Sintertemperatur entspricht. Insbesondere können die Temperaturen beim Sinter- und Lötprozess je nach Löt- und Sinterverfahren recht ähnlich sein, zum Beispiel ca. 240° zum Aufschmelzen des Lotes und zum Sintern. Somit ist das Erhitzen der Zwischenschicht 3 bzw. der Anordnung zum Zweck des Sinterns ausreichend, um ein Aufschmelzen des Lotes und eine zuverlässige Ausbildung der Lötstelle zu gewährleisten. Insbesondere braucht der Sinterprozess deshalb nicht speziell angepasst werden. Von Vorteil ist bei dieser Variante, dass die Lotverbindung und die Sinterverbindung besonders leicht in einem Arbeitsschritt hergestellt werden können.

Vorzugsweise entspricht die Dicke des Lot-Preforms im Wesentlichen der Dicke des Sinter-Werkstoffs, bevor die beiden Verbindungen durch Erhitzen und ggf. Ausüben von Druck geschaffen werden. Insbesondere ist die Dicke des Lot-Preforms bis auf weniger als ± 10 µm bzw. ± 10 %, vorzugsweise weniger als ± 5 µm bzw. ± 5 %, gleich der Dicke des Sinter-Werkstoffs.

In manchen Beispielen kann die Schichtdicke 9 des Lot-Preforms etwas dicker als die Schichtdicke 9 des Sinter-Werkstoffs gewählt werden, d.h. bspw. um 5 % bis 15 % bzw. ca. 5 µm bis 15 µm dicker. Die genannten Schichtdicken des Sintermaterials bzw. des Lots beziehen sich dabei auf den Status der Anordnung, bevor die beiden Verbindungen durch Erhitzen und ggf. Ausüben von Druck geschaffen werden.

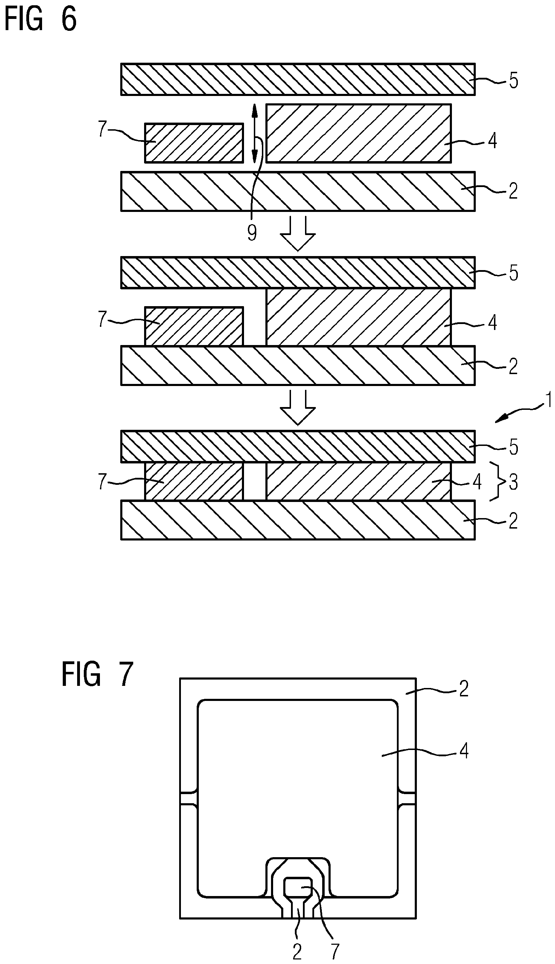

Figur 6 zeigt ein Ablaufdiagramm eines vierten Ausführungsbeispiels des vorgeschlagenen Verfahrens. Wiederum werden das Substrat 2, das Sintermaterial für den Fügebereich 4, das Lot-Preform für den Lotbereich 7 und das Leistungs-Bauelement 5 bereitgestellt und passend angeordnet. Wiederum lediglich aus Gründen der Übersichtlichkeit wird dabei die jeweilige Anschlussstelle 6 in Figur 6 nicht näher dargestellt.

Gemäß diesem Ausführungsbeispiel wird zunächst gesintert und anschließend gelötet. Hierzu kann insbesondere ein hochschmelzendes Lot verwendet werden, welches eine Schmelztemperatur aufweist, die größer als die Sintertemperatur ist. Während des Herstellungsprozesses des vorgeschlagenen Leistungsmoduls 1 wird die Zwischenschicht 3 bzw. Anordnung zunächst auf die Sintertemperatur erhitzt und ggf. Druck auf die Zwischenschicht bzw. Anordnung ausgeübt, wodurch die Sinterverbindung geschaffen wird. Dann wird die Zwischenschicht 3 bzw. die Anordnung durch weitere Temperaturerhöhung auf die Schmelztemperatur des Lots erhitzt, wodurch die Lotverbindung geschaffen wird. Die Schaffung der Lotverbindung kann dabei in einem Prozessschritt zusammen mit der Schaffung der Sinterverbindung oder in einem, davon abgetrennten Prozessschritten durchgeführt werden.

Vorzugsweise ist dabei der Sinter-Werkstoff um 10 % bis 40 % dicker als das Lot-Preform, vorzugsweise 15 % bis 25 %. In einigen Beispielen ist der Sinter-Werkstoff dabei ca. 10 µm bis 40 µm dicker als das Lot-Preform, vorzugsweise 15 µm bis 25 µm. Die genannten Schichtdicken des Sintermaterials bzw. des Lots beziehen sich dabei auf den Status der Anordnung, bevor die beiden Verbindungen durch Erhitzen und ggf. Ausüben von Druck geschaffen werden.

Figur 7 zeigt einen ersten Zwischenstand bei der Herstellung eines dritten Ausführungsbeispiels des vorgeschlagenen Leistungsmoduls 1. Dargestellt ist dabei eine Draufsicht auf das Substrat 2, auf welchem bei diesem dritten Ausführungsbeispiel eine Sinter-Paste für den Fügebereich 4 aufgebracht ist. Ferner ist auf das Substrat 2 ein Lot-Preform für den Lotbereich 7 aufgebracht, wobei der Lotbereich 7 beabstandet von dem Fügebereich 4 angeordnet ist.

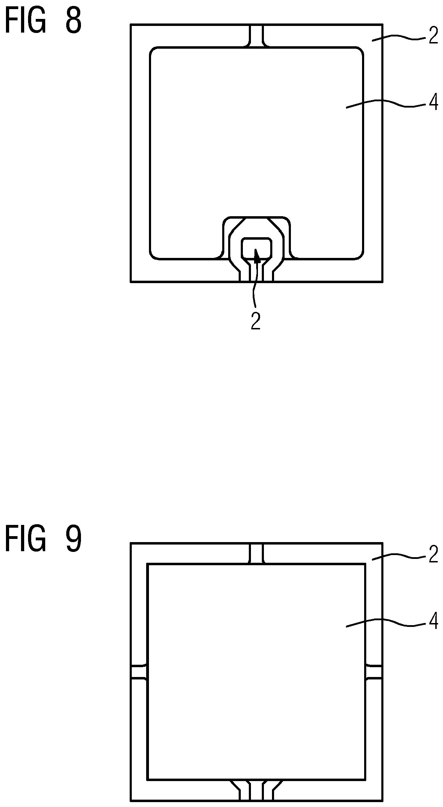

Figuren 8 und 9 zeigen einen ersten und zweiten Zwischenstand bei der Herstellung eines vierten Ausführungsbeispiels des vorgeschlagenen Leistungsmoduls 1. Wie auch bei dem in der Figur 7 dargestellten dritten Ausführungsbeispiel, ist wiederum eine Draufsicht auf das Substrat 2 dargestellt. Wie in Figur 8 dargestellt, sind auf dem Substrat 2 ein Sinter-Preform für den gesinterte Fügebereich 4 ein Lot-Preform für den Lotbereich 7 aufgebracht, wobei der Lotbereich 7 wiederum beabstandet von dem gesinterte Fügebereich 4 angeordnet ist. Wie in Figur 9 dargestellt ist, ist das Leistungs-Bauelement 5 mit dem gesinterte Fügebereich 4 und dem Lotbereich 7 verbunden und deckt diese bei der dargestellten Draufsicht nunmehr ab.

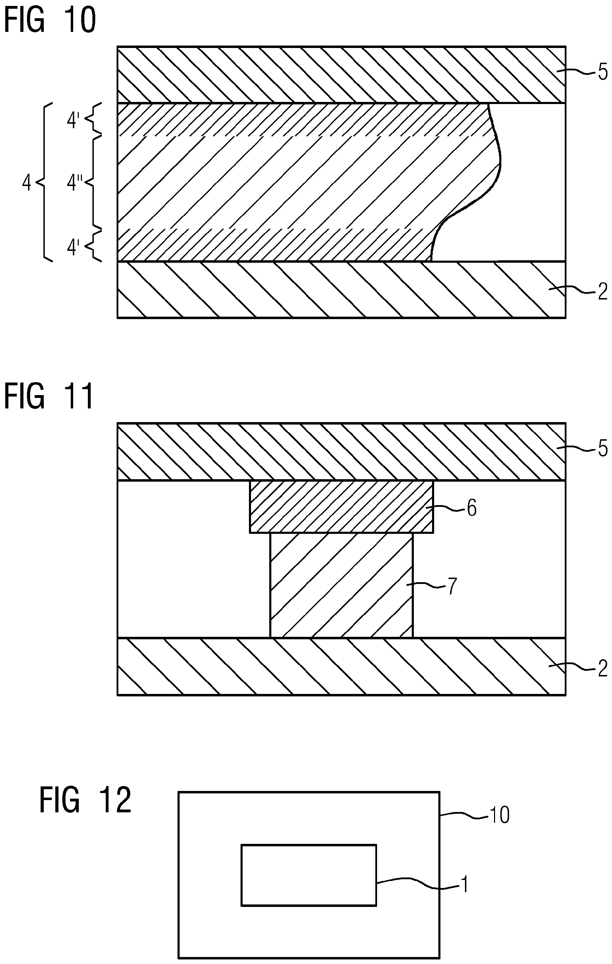

Figuren 10 und 11 zeigen Querschnitte durch ein fünftes Ausführungsbeispiel des vorgeschlagenen Leistungsmoduls 1.

Figur 10 zeigt dabei den Querschnitt durch den gesinterte Fügebereich 4 des Leistungsmoduls 1. Für diesen gesinterte Fügebereich 4 wurde ein Sinter-Preform verwendet, welches nach dem Sintern einen harten Sinterkern 4" aufweist. Der gesinterte Fügebereich 4 umfasst weiterhin zwei, teils während des Sinterns ausgebildete Randbereiche 4', von denen einer zwischen dem Sinterkern 4" und dem Substrat 2 und der andere zwischen dem Sinterkern 4" und dem Leistungs-Bauelement 5 angeordnet ist. Beispielsweise kann der gesinterte Fügebereich 4 einen als Vollmaterial ausgestalteten Sinterkern 4" aufweisen, welcher auf beiden Seiten, das heißt zum Leistungs-Bauelement 5 hin und zum Substrat 2 hin, jeweils ein Sintermaterial aufweist. Zusätzlich wäre auch ein geschichteter, gesinterte Fügebereich 4 denkbar, bei welchem sich Sintermaterial und Vollmaterial schichtweise abwechseln, z.B. Sintermaterial-Vollmaterial-Sintermaterial-Vollmaterial-Sintermaterial.

Figur 11 zeigt dabei den Querschnitt durch den Lotbereich 7 des Leistungsmoduls 1. Für diesen Lotbereich 7 wurde ein Lot-Preform verwendet. Weiterhin ist eine Anschlussstelle 6 dargestellt, welche zwischen dem übrigen Leistungs-Bauelement 5 und dem Lotbereich 7 angeordnet ist. Der Lotbereich 7 ist dabei zwischen der Anschlussstelle 6 und dem Substrat 7 angeordnet.

Figur 12 zeigt ein Ausführungsbeispiel des vorgeschlagenen elektrischen Gerätes 10. Das elektrische Gerät 10 weist das vorgeschlagene Leistungsmodul 1 auf. Bspw. ist das elektrische Gerät 10 als Umrichter ausgestaltet.

## Patentansprüche

1. Leistungsmodul (1) umfassend
- ein Substrat (2),
- eine elektrisch leitende Zwischenschicht (3), welche auf dem Substrat (2) angeordnet ist und welche einen mittels Sinters hergestellten Fügebereich (4) aufweist, und
- zumindest ein Leistungs-Bauelement (5), welches jeweils auf der Zwischenschicht (3) angeordnet ist und welches jeweils zumindest eine mit der Zwischenschicht (3) verbundene Anschlussstelle (6) aufweist,
**gekennzeichnet dadurch, dass**
- die Zwischenschicht (3) im Bereich der jeweiligen Anschlussstelle (6) einen mittels eines Lot-Preforms hergestellten Lotbereich (7) aufweist, welcher mit der jeweiligen Anschlussstelle (6) verbunden ist.

2. Leistungsmodul (1) nach Anspruch 1,
wobei der mittels Sinters hergestellten Fügebereich (4) mittels eines Sinter-Preforms hergestellt ist.

3. Leistungsmodul (1) nach Anspruch 1,
wobei der mittels Sinters hergestellten Fügebereich (4) mittels 3D-Druckes, mittels eines Beschichtungsverfahrens oder mittels Sieb-/Schablonendruckes ausgebildet ist.

4. Leistungsmodul (1) nach zumindest einem der vorhergehenden Ansprüche,
wobei der jeweilige Lotbereich (7) bzw. das jeweilige Lot-Preform flussmittelfrei ist.

5. Leistungsmodul (1) nach zumindest einem der vorhergehenden Ansprüche,
wobei der mittels Sinters hergestellten Fügebereich (4) und der jeweilige Lotbereich (7) zwischen dem Substrat (2) und dem jeweiligen Leistungs-Bauelement (5) nebeneinander angeordnet sind und im Wesentlichen dieselbe Schichtdicke (9) aufweisen.

6. Leistungsmodul (1) nach zumindest einem der vorhergehenden Ansprüche,
wobei der jeweilige Lotbereich (7) einen Querschnitt von höchstens ca. 9 mm², insb. von höchstens ca. 4 mm², aufweist.

7. Leistungsmodul (1) nach zumindest einem der vorhergehenden Ansprüche,
wobei das Substrat (2) ein Direct-Bonded-Copper(DCB)-Substrat, ein Insulated-Metal-Substrate (IMS), ein Active-Metal-Brazing(AMB)-Substrat oder eine Leiterplatte umfasst, und
wobei das Substrat (2) an seiner, der Zwischenschicht (3) zugewandten Seite eine Edelmetalloberfläche (8) aufweist.

8. Elektrisches Gerät (10), insbesondere Umrichter, aufweisend zumindest ein Leistungsmodul (1) nach zumindest einem der vorhergehenden Ansprüche.

9. Verfahren zur Herstellung eines Leistungsmoduls (1) nach einem der Ansprüche 1 bis 6 umfassend die Verfahrensschritte:
- Bereitstellen des Substrates (2),
- Anordnen des Sintermaterials für den zu sinternden Fügebereich (4) und des Lots für den jeweiligen Lotbereich (7) auf dem Substrat (2) zur Ausbildung der Zwischenschicht (3),
wobei das Lot für den jeweiligen Lotbereich (7) im Bereich der jeweiligen Anschlussstelle (6) des jeweiligen Leistungs-Bauelements (5) als Lot-Preform bereitgestellt wird,
- Anordnen des jeweiligen Leistungs-Bauelements (5) auf dem Fügebereich (4) und dem jeweiligen Lotbereich (7) bzw. auf der Zwischenschicht (3), und
- Erhitzen der Zwischenschicht (3) auf die Schmelztemperatur des Lots bzw. auf die Sintertemperatur.

10. Verfahren nach Anspruch 9, wobei die Zwischenschicht (3) auf die Schmelztemperatur des Lots erhitzt wird, wenn die Schmelztemperatur des Lots höher ist als die Sintertemperatur, oder auf die Sintertemperatur erhitzt wird, wenn die Sintertemperatur höher ist als die Schmelztemperatur des Lots.

11. Verfahren nach einem der Ansprüche 9 oder 10,
wobei die Schichtdicke (9) des Sintermaterials für den mittels Sinters hergestellten Fügebereich (4) größer bzw. kleiner ist als die Schichtdicke (9) des Lots für den jeweiligen Lotbereich (7), wenn die Sintertemperatur kleiner bzw. größer ist als die Schmelztemperatur des Lots.

12. Verfahren nach Anspruch 9, wobei die Schmelztemperatur des Lots im Wesentlichen gleich der Sintertemperatur ist.

13. Verfahren nach einem der Ansprüche 9 oder 12, wobei die Schichtdicke (9) des Sintermaterials für den mittels Sinters hergestellten Fügebereich (4) im Wesentlichen gleich der Schichtdicke (9) des Lots für den jeweiligen Lotbereich (7) ist.
